# EUROPÄISCHE PATENTANMELDUNG

(11) **EP 3 113 232 A1**
(43) Veröffentlichungstag der Anmeldung: **04.01.2017**
(21) Anmeldenummer: 15020105.1
(22) Anmeldetag: 30.06.2015
(51) Int. Cl.: H01L 31/02

(54) **OPTIMIERTES PHOTOVOLTAIK MODUL MIT BYPASS-NETZWERK**

(71) Anmelder: Naebauer, Anton, 80805 München (DE)
(72) Erfinder: Naebauer, Anton, 80805 München (DE)

(57) **Zusammenfassung**

Die vorliegende Erfindung betrifft Photovoltaik-Modul mit mindestens einem Bypass-Netzwerk mit Daten verarbeitende Einheit, das in Verbindung mit einem für mindestens einen gesamten Modulstring vorgesehenen Stringüberwachungs-Server eine einfache und kosteneffektive Erkennung von Störungen im Stromkreis auch bei nachts unbeleuchteten PV-Modulen ermöglicht,
dadurch gekennzeichnet, dass
das Bypass-Netzwerk gebildet wird durch die Parallelschaltung
eines die negative Spannung über dem Bypass begrenzenden Bauteils,
eines zusätzlichen Leistungsschalters
sowie des Eingangs eines DC-DC Spannungswandlers
wobei das Bypass-Netzwerk im aktiven Bereich - sofern der Strom durch das Bypass-Netzwerk unterhalb des Trigger-Stromes liegt - dauerhaft einen ersten aktiven Zustand einnehmen kann
in dem der zusätzliche Leistungsschalter nicht eingeschaltet ist,
und in dem ein signifikanter Strom über das Bypass-Netzwerk fließt,
wobei der DC-DC Spannungswandler in der Lage ist, die zum Bypass-Netzwerk gehörende Daten verarbeitende Einheit, die bei Bedarf den zusätzlichen Leistungsschalter ansteuert, mit Energie zu versorgen sofern die Spannung über dem Bypass-Netzwerk negativer wird als die Start-up-Spannung (Uₛₜₐᵣₜ) des DC-DC-Wandlers.

## Beschreibung

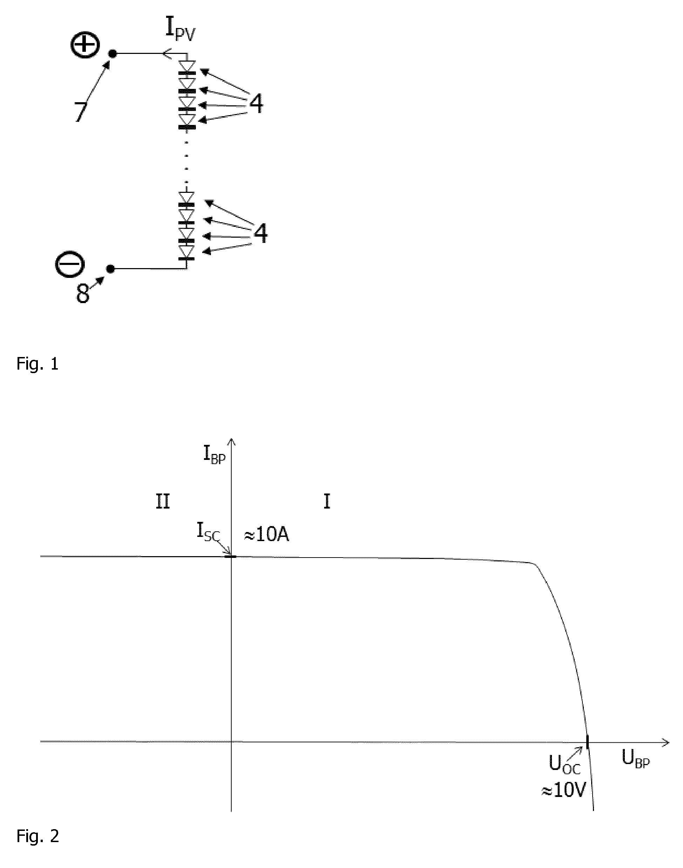

In der Photovoltaik wird die Serienschaltung von vielen Solarzellen (PV-Zellen) als ein String (Fig.1) bezeichnet. In der Praxis beinhaltet ein String mindestens eine Zelle kann aber häufig auch mehr als 1000 hintereinander geschaltete Zellen beinhalten. Ein derartig langer String wird beispielsweise durch eine Serienschaltung von etwa 10 bis 60 Modulen mit jeweils 20 bis 100 seriell verschalteten Zellen realisiert.

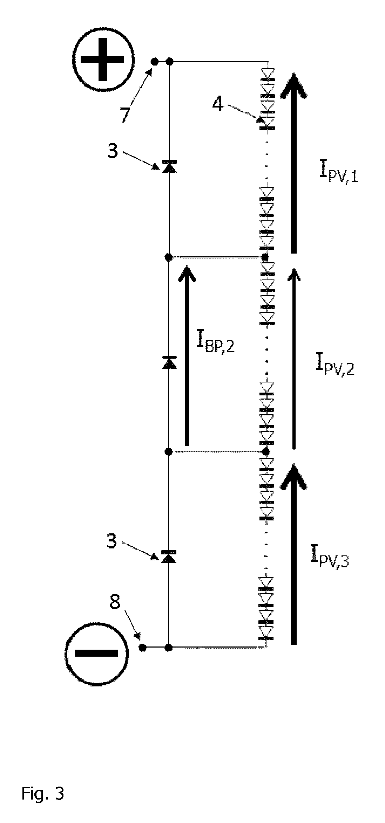

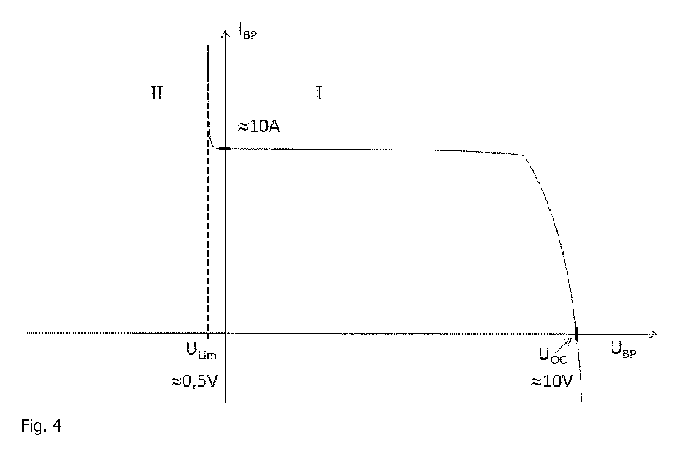

Hier wird beispielhaft ein Teil eines langen Strings, ein Teilstring mit beispielsweise 20 seriell verschalteten Zellen betrachtet. Fig. 2 zeigt grob die Kennlinie eines solchen Teilstrings der zum Beispiel eine Leerlaufspannung U_{OC} von ca. 10 V hat und einen Kurzschlussstrom I_{SC} von ca. 10 A aufweist. Solange der betrachtete Teilstring im I. Quadranten betrieben wird, gibt er Energie ab. Wenn er im II. Quadranten betrieben wird, wird er zum Energie Verbraucher und zwar um so mehr, je stärker die Umpolung des Teilstrings ist (d. h. je negativer die Spannung des Teilstrings wird). Bei Photovoltaik-Modulen (PV-Modulen) werden in der Regel Bypassdioden eingebaut, damit im Falle einer verminderten Leistung von Zellen in einem Teilstring der Strom teilweise um diese Zellen herumgeleitet wird (Bypass-Fall). Damit werden die Ertragsverluste durch Zellen mit verminderter Leitung begrenzt und verhindert, dass Zellen mit Minderleistung (die nicht in ausreichendem Maße Strom erzeugen) zu große Leistungen in Wärme umwandeln. Dies ist in Fig. 3 veranschaulicht, wo drei seriell verschaltete Teilstrings mit jeweils einer parallelen Bypass-Diode zu sehen sind, und wobei der mittlere Teilstring verschattet ist, so dass der Strom I_{PV,2} durch die Zellen dieses Strings deutlich geringer ist (als I_{PV,1} und I_{PV,3}), was auch durch die Stichstärken der Pfeile veranschaulicht wird. Beim mittleren String fließt ein Großteil des Stromes (I_{BP,2}) am String vorbei, durch die dazugehörige Bypass-Diode, wodurch verhindert wird, dass über dem mittleren String eine zu hohe negative Spannung aufgebaut wird. Fig. 4 zeigt die Kennlinie eines Teilstrings dem eine Bypass-Diode parallel geschaltet ist. Deutlich zu erkennen ist, dass hierbei auch bei hohen Strömen die negative Spannung (und damit der elektrische Verlust in diesem String) in Grenzen bleibt. Beispielsweise kann durch eine geeignete Diode die negative Spannung über dem Teilstring auf einen Absolutwert von ca. 0,5 V begrenzt werden. Bei PV-Modulen werden üblicherweise Halbleiterdioden auf Silizium Basis verwendet. Da bei den Bypassdioden unter dem Gesichtspunkt einer geringen Wärmeentwicklung eine geringe Durchgangsspannung im Bypass-Fall (in dem die Dioden in Leitrichtung gepolt sind) gewünscht wird, werden dafür häufig auch Schottky-Dioden verwendet, die sich durch einen geringen Spannungsabfall im Durchgangsbereich auszeichnen.

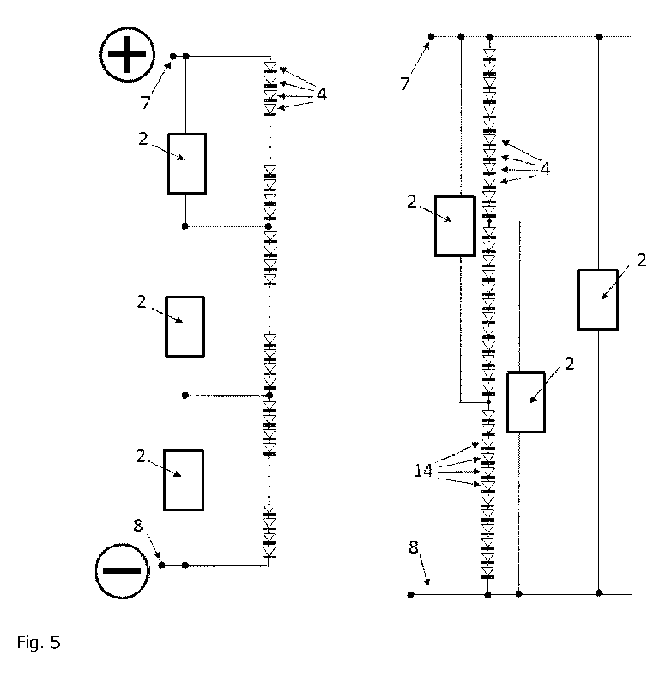

Die beschriebene Bypassdiode stellt einen einfachen Fall eines Bypass-Netzwerks dar und erfüllt die wichtigste Funktion, die Verbesserung der Performance des Solarmoduls wenn Teile des Moduls verschattet sind, oder wenn dem Solarmodul von außen ein höherer Strom eingeprägt wird als die PV-Zellen erzeugen können. Dieses Bypass-Netzwerk ist dabei immer einer Serienschaltung von mehreren Solarzellen parallel geschaltet, wobei diese Kombination in diesem Dokument als Teilstring mit Bypass bezeichnet wird. Ein Solarmodul kann auch mehrere Bypass-Netzwerke beinhalten, wobei es grundsätzlich auch möglich ist, dass Zellen eines Moduls zu mehreren Teilstrings mit parallelem Bypass gehören. Fig. 5 zeigt mehrere Beispiele, wie bei einem Solarmodul Teilstrings mit parallelem Bypass gebildet sein können. Für die Polarität des Bypass-Netzwerkes gilt, dass der Plus-Pol des Bypass-Netzwerkes mit dem Plus-Pol des stromerzeugenden Teilstrings verbunden ist, und der Minus-Pol des Bypass-Netzwerkes mit dem Minus-Pol des stromerzeugenden Teilstrings verbunden ist. Ein Teilstring kann auch durch die Parallelschaltung von mehreren Gruppen von seriell verschalteten Zellen gebildet werden.

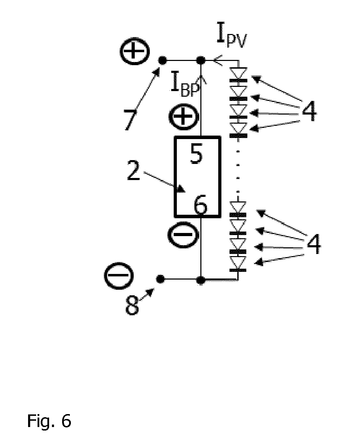

Wie in Fig. 6 gezeigt, ist die Stromrichtung (I_{BP} beim Bypass und I_{PV} bei der Solarzelle) sowohl bei den Solarzellen als auch beim Bypass-Netzwerk so definiert, dass ein positiver Strom einen von Pluspol herausfließenden Strom darstellt. Grundsätzlich kann das Bypass-Netzwerk aus mehreren Bauteilen aufgebaut sein und auch neben den beschriebenen Funktionen noch zusätzliche Funktionen übernehmen, wobei anzustreben ist, dass die Funktionen weitgehend durch integrierte Schaltungen realisiert werden, um die Funktionen kostengünstig realisieren zu können.

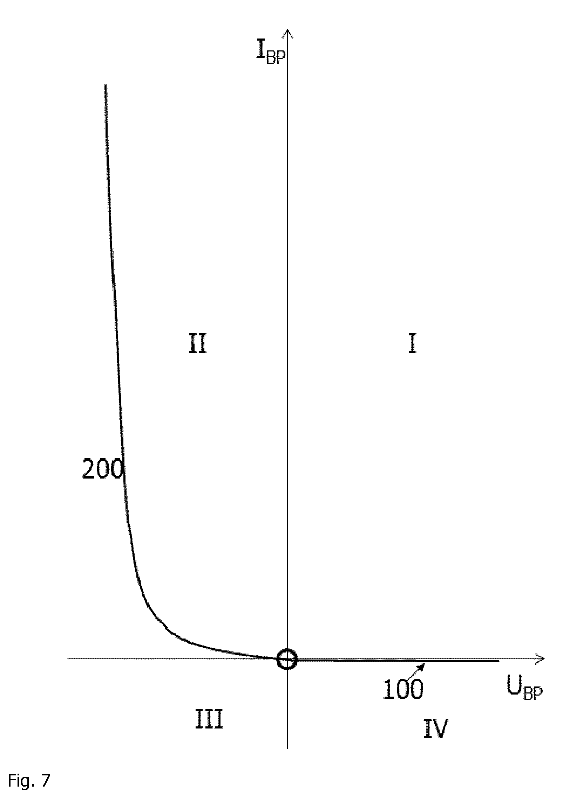

Bei einem einfachen, nur durch eine Diode gebildeten Bypass-Netzwerk gibt es im Wesentlichen zwei Arbeitsbereiche des Bypass-Netzwerks, die in der in Fig. 7 dargestellten Kennlinie als 100 und 200 bezeichnet werden:
Arbeitsbereich 100: Bypass-Netzwerk arbeitet nicht im aktiven Bereich (Kennlinienverlauf im IV. Quadrant):
   Am Pluspol des Bypass-Netzwerks (Kathode der Bypass-Diode) liegt eine positive Spannung und am Minuspol des Bypass-Netzwerks (Anode der Bypass-Diode) liegt eine negative Spannung. Das Bypass-Netzwerk ist nicht aktiv. Es fließt nur ein geringer parasitärer Strom durch das Bypass-Netzwerk. Der dem Bypass-Netzwerk parallel geschaltete Zellstring erzeugt elektrische Energie, die abgegeben werden kann.
Arbeitsbereich 200: Bypass-Netzwerk arbeitet im aktiven Bereich (Kennlinienverlauf im II. Quadrant):
   Der von außen der Parallelschaltung von Zellstring und Bypass-Netzwerk eingeprägte Strom ist größer als der vom Zellstring erzeugt Strom. Dies führt dazu, dass der überschüssige Strom über das Bypass-Netzwerk fließt. Am Pluspol des Bypass-Netzwerks (Kathode der Bypassdiode) liegt eine negative Spannung und am Minuspol des Bypass-Netzwerks (Anode der Bypassdiode) liegt eine positive Spannung. Das Bypass-Netzwerk ist aktiv. Es fließt Strom durch das Bypass-Netzwerk. Das Bypass-Netzwerk und der dem Bypass-Netzwerk parallel geschaltete Zellstring wird zum Energieverbraucher. Das Bypass-Netzwerk begrenzt die negative Spannung über dem parallel geschalteten String von Zellen und damit auch den elektrischen Verlust, der in den Zellen entsteht. Gleichzeitig wird dadurch der elektrische Stress auf die Zellen in dem Teilstring vermindert und es werden Hotspots vermieden.

Um die Funktionalität des Bypass-Netzwerks zu verbessern und insbesondere die im Arbeitsbereich 200 im Bypass-Netzwerk in Wärme umzusetzende Energie zu reduzieren, werden die heute üblicherweise verwendete Dioden (oder Shottky-Dioden) in einigen Fällen durch eine Kombination von Controller und zusätzlichem Leistungsschalter (in der Regel ein MOSFET) ergänzt, so dass bei aktivem Bypass-Netzwerk ein gegenüber den herkömmlichen Dioden deutlich geringerer absoluter Spannungsabfall auftritt (typischerweise einige 10 mV im Vergleich zu mehreren 100 mV). Da der daraus resultierende geringe Absolutwert des Spannungsabfalls über dem Bypass-Netzwerk nicht ausreichend ist, den Controller direkt mit Energie zu versorgen und die für die Ansteuerung des zusätzlichen Leistungsschalters erforderliche Energie auf einfache Weise bereitzustellen, muss die Energieversorgung durch zusätzliche Maßnahmen ermöglicht werden. Am Markt sind verschiedene Produkte (genannt z. B. Smart Bypass Diode) verfügbar, bei denen zusätzliche Maßnahmen angewandt werden. Zum Beispiel wird bei der Smart Bypass Diode LM 74611 von Texas Instruments als zusätzlicher Leistungsschalter ein N-Kanal-MOSFET verwendet, der bei aktivem Bypass im inversen Betrieb arbeitet (Drain negativ gegenüber Source (Source mit Body verbunden) wodurch sichergestellt wird, dass die Bodydiode des MOSFET im Arbeitsbereich 100 (Bypass inaktiv) gesperrt ist und im Arbeitsbereich 200 (aktiver Bypass) in Flussrichtung betrieben wird). Weiterhin sind noch ein Energiespeicher und eine Ladungspumpe vorhanden. Wenn nun bei ausgeschaltetem Leistungsschalter Strom durch das aktive Bypass-Netzwerk fließt, gibt es über der Bodydiode des MOSFET einen Spannungsabfall (typischerweise 0,4 ... 0,7 V) der ausreicht um die Ladungspumpe zu starten und damit den Energiespeicher (Kondensator) zu laden. Sobald der Energiespeicher eine ausreichende Ladungsmenge verfügt, wird der Leistungsschalter eingeschaltet, so dass der Absolutwert des Spannungsabfalls über dem Bypass-Netzwerk sehr gering wird (typischerweise einige 10 mV). Dieser geringe Spannungsabfall reicht nicht mehr aus, die Ladungspumpe zu betreiben, so dass die Ladung des Energiespeichers wieder absinkt (da der Controller ständig einen geringen Strom verbraucht und wegen parasitärer Entladung des Energiespeichers durch Leckströme). Wenn im aktiven Arbeitsbereich die Energie des Energiespeichers eine bestimmte Grenze unterschreitet, wird der zusätzliche Leistungsschalter wieder ausgeschaltet und die Spannung über dem Bypass-Netzwerk steigt wieder an, wobei der Strom jetzt wieder über die Body-Diode des MOSFET fließt und der Zyklus von neuem beginnt. In US020090184746A1 wird ebenfalls ein ähnliches Verfahren beschrieben, wie die Energie für den Controller und den Leistungsschalter zur Verfügung gestellt werden kann.

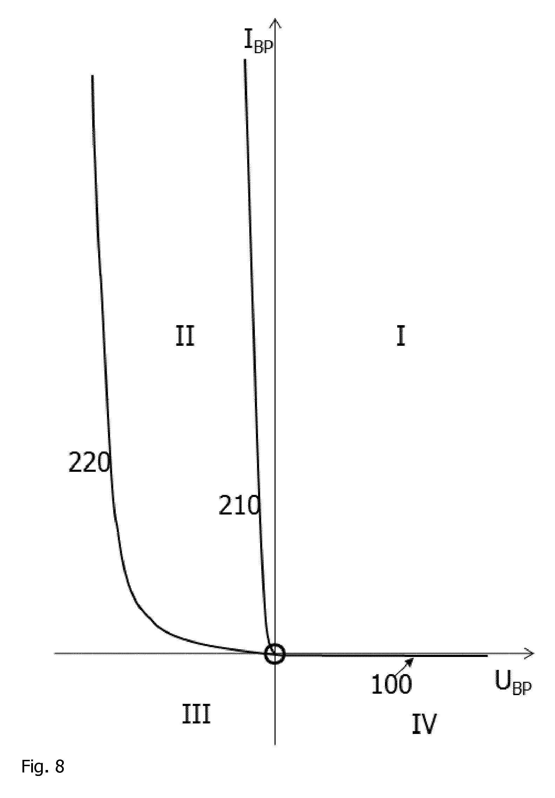

Bei einer typischen Smart Bypass-Diode gibt es demzufolge statt dem vorher beschriebenen Arbeitsbereich 200 zumindest die beiden im Folgenden beschriebenen Arbeitsbereiche, deren dazugehörenden Kennlinien in Fig. 8 zu sehen sind:
Arbeitsbereich 210: Bypass-Netzwerk ist aktiv (arbeitet im II. Quadrant) wobei der zusätzliche Bypass Schalter eingeschaltet ist:
   Am Pluspol des Bypass-Netzwerks liegt eine negative Spannung und am Minuspol des Bypass-Netzwerks liegt eine positive Spannung. Über dem Bypass-Netzwerk fällt nur eine sehr geringe absolute Spannung (typischerweise einige 10 mV) ab, die nicht ausreicht um die Schaltung mit der der Energiespeicher gefüllt wird zu betreiben. Die Leistung, die in diesem Arbeitsbereich in Wärme umgesetzt wird ist relativ gering.
Arbeitsbereich 220: Bypass-Netzwerk ist aktiv wobei der zusätzliche Bypass Schalter nicht eingeschaltet ist:
   Der Spannungsabfall über dem Bypass-Netzwerk wird durch die im Bypass-Netzwerk vorhandene spannungsbegrenzende Diode bestimmt und der Absolutwert steigt typischerweise auf einige 100 mV an wodurch über eine Ladungspumpe das Aufladen eines Energiespeichers ermöglicht wird. Die Leistung, die in diesem Arbeitsbereich in Wärme umgesetzt wird, ist relativ hoch. Sofern der zusätzliche Schalter wie oben beschrieben von einem N-Kanal MOS-Transistor gebildet wird, handelt es sich bei der spannungsbegrenzenden Diode um die Bodydiode des N-Kanal MOS-Transistors.

Um die Wärmeentwicklung des Bypass-Netzwerks möglichst gering zu halten wird durch geschickte Auslegung der Schaltung erreicht, dass die Zeit im Arbeitsbereich 210 deutlich größer ist als die Zeit im Arbeitsbereich 220 (z. B. um den Faktor 50). Bei einem aktiven Bypass-Netzwerk ist also der zusätzlich Bypass-Schalter möglichst lange eingeschaltet und möglichst kurz ausgeschaltet.

Der Erfindung liegt die Aufgabe zu Grunde, ein Photovoltaik-Modul mit mindestens einem Bypass-Netzwerk mit Daten verarbeitender Einheit zu schaffen, wobei die Funktionalität des Bypass-Netzwerks gegenüber einer Smart Bypass-Diode erweitert ist und das Bypass-Netzwerk in Verbindung mit einem für mindestens einen gesamten Modulstring vorgesehenen String-überwachungs-Server eine einfache und kosteneffektive Erkennung von Störungen im Stromkreis (z. B. um einen Diebstahl Alarm abzuleiten!) auch bei nachts unbeleuchteten PV-Modulen ermöglicht.

Dies wird erfindungsgemäß dadurch erreicht, dass das Bypass-Netzwerk gebildet wird durch die Parallelschaltung
eines die negative Spannung über dem Bypass begrenzenden Bauteils,
eines zusätzlichen Leistungsschalters
sowie des Eingangs eines DC-DC Spannungswandlers
wobei das Bypass-Netzwerk im aktiven Bereich - sofern der Strom durch das Bypass-Netzwerk unterhalb des Trigger-Stromes liegt - dauerhaft einen ersten aktiven Zustand einnehmen kann,
in dem der zusätzliche Leistungsschalter nicht eingeschaltet ist, und in dem ein signifikanter Strom über das Bypass-Netzwerk fließt
und wobei der DC-DC Spannungswandler in der Lage ist die zum Bypass-Netzwerks gehörende Daten verarbeitende Einheit, die bei Bedarf den zusätzlichen Leistungsschalter ansteuert, mit Energie zu versorgen sofern die Spannung über dem Bypass-Netzwerk negativer wird als die Start-up-Spannung (Uₛₜₐᵣₜ) des DC-DC-Wandlers.

Durch diese erfindungsgemäße Lösung ist es möglich, dass bei unbeleuchteten Zellen die Elektronik des Bypass-Netzwerkes und dabei insbesondere die Daten verarbeitende Einheit mit Energie aus dem String-Stromkreis versorgt wird. Die benötigte Energie muss bei unbeleuchteten Strings vom String-überwachungs-Server in den Stringstromkreis eingespeist werden.

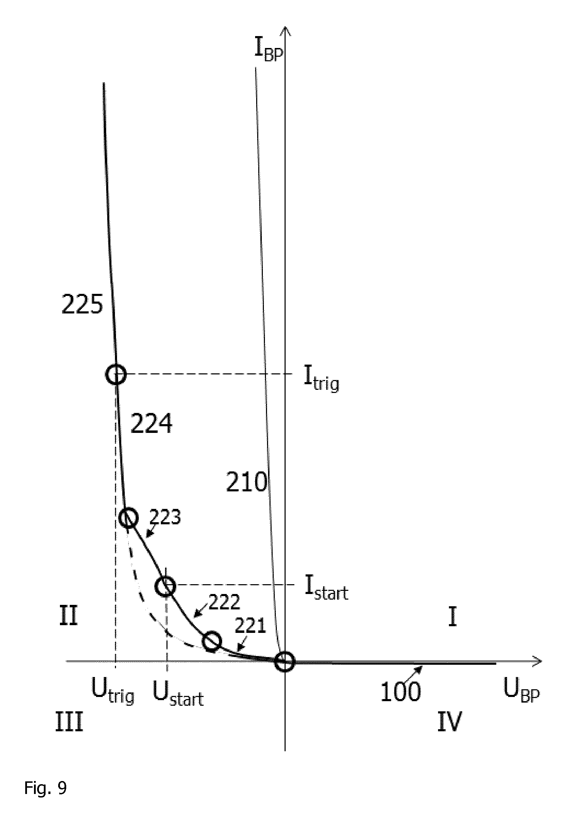

In Fig. 9 sind die Arbeitsbereiche des erfindungsgemäßen Bypass-Netzwerks für das erfindungsgemäße Modul erläutert. Der Arbeitsbereich 100, der bei positiver Spannung über dem Bypass-Netzwerk gilt, ist unverändert gegenüber Fig. 8 und damit bereits erläutert. Hier ist das Bypass-Netzwerk nicht aktiv, es fließt kein wesentlicher Strom durch das Bypass-Netzwerk. Die dazugehörende Kennlinie 100 liegt im IV. Quadranten. Der DC-DC-Wandler und der zusätzliche Leistungsschalter sind so auszulegen, dass bei positiver Spannung am Bypass-Netzwerk kein wesentlicher Strom aufgenommen wird. Aus diesem Grund ist es vorteilhaft, für den zusätzlichen Leistungsschalter einen N-Kanal MOSFET zu verwenden, der im Arbeitsbereich 100 ausgeschaltet ist, und der im aktiven Bereich des Bypass-Netzwerks im inversen Betrieb arbeitet. Hierdurch ist es möglich, die Body-Diode des MOSFET als das Bauteil zu verwenden, das die negative Spannung über dem Bypass begrenzt.

Bei negativer Spannung über dem Bypass-Netzwerk ist das Netzwerk aktiv und es gibt es zwei Kennlinien-äste, die beide im II. Quadranten (negative Spannung und positiver Strom durch das Bypass-Netzwerk) liegen. Der erste Kennlinienast beschreibt wie in Fig. 8 den Arbeitsbereich 210 mit eingeschaltetem zusätzlichem Leistungsschalter. Der zweite Kennlinienast beschreibt das Verhalten bei ausgeschaltetem Leistungsschalter, das zur Veranschaulichung noch in mehrere Arbeitsbereiche 221, ... 225 unterteilt wird. Ausgehend von Spannung 0 in negative Richtung kommt zunächst Arbeitsbereich 221, in dem so gut wie keine wesentlichen Ströme durch das Bypass-Netzwerk fließen. Daran schließt sich Arbeitsbereich 222 an, in dem der Eingangsstrom des DC-DC-Wandlers den Strom durch das Bypass-Netzwerk wesentlich bestimmt. Der Übergang zwischen Beriech 221 und 222 könnte beispielsweise bei 50 ... 150 mV liegen. Insbesondere ist in diesem Bereich der Strom durch das Bauteil das die negative Spannung begrenzt (dies ist in der Regel die Body-Diode, des als zusätzlicher Leistungsschalter arbeitenden MOSFET) deutlich geringer.

Trotz der signifikanten Stromaufnahme des DC-DC-Wandlers ist dieser in diesem Bereich noch nicht in der Lage, die Daten verarbeitende Einheit zuverlässig mit Energie zu versorgen. Dies ist erst bei höherer negativerer Spannung im daran anschließenden Bereich 223 gegeben. Der DC-DC-Wandler muss so ausgelegt sein, dass er schon bei sehr geringen negativen Spannungen arbeitet. Der Übergang von Bereich 222 in Bereich 223 könnte beispielsweise bei -150 ... -300 mV liegen. Damit ist im Bereich 223 die Funktion der Daten verarbeitende Einheit von Seiten der Energieversorgung gewährleistet. Der DC-DC-Wandler kann zusätzlich noch einen Energie-Speicher 34 beinhalten.

Der DC-DC-Wandler sollte am seinem Ausgang bevorzugt eine Spannung im Bereich von 5 ... 15 V erzeugen, die ausreicht die Daten verarbeitende Einheit 36 zu versorgen und insbesondere ausreicht auch den Leistungsschalter 30 so einzuschalten, dass er in eigeschaltetem Zustand auch bei hohen Strömen möglichst geringe elektrische Verluste aufweist.

Mit höherer negativer Spannung steigt der Strom durch das Spannungs-begrenzende Bauteil (in der Regel die Body-Diode des MOSFET) bis im Arbeitsbereich 224 der Strom durch diese Diode den wesentlichen Anteil des Stroms durch das Bypass-Netzwerk darstellt. Beispielsweise kann der Übergang zwischen 223 und 224 bei -300 ... -500 mV stattfinden

Mit weiter steigender negativer Spannung steigt der Bypass-Strom weiter an, bis bei U_{trig} der Triggerstrom I_{trig} überschritten wird und damit der Arbeitsbereich 225 erreicht wird. In diesem Arbeitsbereich wird der Übergang in den Arbeitsbereich 210 initiiert, der kurz darauf auch eingenommen wird. Beispielsweise könnte U_{trig} bei -500 ... -600 mV liegen. I_{trig} kann beispielsweise bei 1 ... 100 mA liegen.

Die Arbeitsbereiche 222, 223 und 224 erfüllen die Kriterien für den oben erwähnten ersten Zustand des Bypass-Netzwerkes.

Um den Kennlinienverlauf in den Bereichen 222, 223 und 224 zu beeinflussen kann dem Bypass-Netzwerk noch ein Kennlinien formendes Netzwerk 32 durch ParallelSchaltung hinzugeführt werden. Dies ist von Vorteil, wenn die Serienschaltung vieler PV-Module vorliegt, und bei unbeleuchteten Modulen die Kennlinie der Serienschaltung von Modulen ausgewertet wird. Wenn durch ein Kennlinien-formendes Netzwerk sichergestellt ist, dass alle Module über Bypass-Netzwerke mit bekannter, gut reproduzierbarer Kennlinie verfügen, können aus der Kennlinienmessung des Strings präzisere Rückschlüsse gezogen werden. Darüber hinaus kann der Kennlinien-Verlauf in eine vorteilhafte Form gebracht werden, so dass ein gut reproduzierbarer Zusammenhang zwischen Strom und Spannung besteht.

Das Kennlinien formende Netzwerk 32 kann beispielsweise bestehen aus einer Serienschaltung eines Widerstands und einer Schottky-Diode mit sehr geringer Durchgangsspannung (von beispielsweise 150 mV). Die Schottky-Diode stellt sicher, dass Strom nur fließt wenn das Bypass-Netzwerk im aktiven Bereich arbeitet. Die I(U)-Kennlinie ist dann in einem gewissen Bereich wesentlich durch den Widerstand beeinflusst. Das Kennlinien-formende Netzwerk kann insbesondere auch im Arbeitsbereich 222 einen höheren Strom als der DC-DC-Wandler aufnehmen und damit auch hier die Kennlinie wesentlich beeinflussen.

Die Diebstahl Überwachung erfolgt in Zusammenarbeit mit dem Stringüberwachungs-Server nachts beispielsweise folgendermaßen. Sofern alle Module unbeleuchtet sind und keinen Strom abgeben, wird vom String-überwachungs-Server dem String ein positiver Strom unterhalb des Triggerstroms des Bypass-Netzwerks eingeprägt, der bei unbeleuchtetem Teilstrings dazu führt, dass das jeweilige Bypass-Netzwerk in den ersten aktiven Zustand versetzt wird. Sofern es im Bereich 222, 223 oder 224 betrieben wird, kann durch Auswertung des Spannungsabfalls über dem String eine Störung der Verschaltung der Module im String festgestellt werden (z. B. vollständige elektrische Unterbrechung oder unerwartete Spannung über dem String). Sofern eine unerwartet hohe Störung festgestellt wird, kann Alarm ausgelöst werden.

Um die Bypass-Netzwerke des betrachteten Strings in den ersten aktiven Zustand zu versetzen ist bei jedem Teilstring (bzw. Modul) eine negative Spannung von beispielsweise ca. 500 mV erforderlich. Bei einer Serienschaltung von 60 Teilstrings ist für den gesamten String demzufolge eine gegenüber der normalen String-spannung negative Versorgungsspannung von ca. 30 V erforderlich. Die Schaltung im String-Überwachungs-Server, die einen ganzen String sowohl tagsüber als auch nachts überwacht, muss daher in der Lage sein, die Strings die bei Beleuchtung mehrere kW auf einem Spannungspegel von mehreren 100V liefern, nachts mit einem Strom von einigen mA und einer negativen Spannung von einigen 10 V zu versorgen. Um bei einer derartigen "String-überwachung" den Kontrollmodus umzuschalten von Stromerzeugung und Stromüberwachung (tags) auf Kontrolle der String-Verschaltung auf Störung (nachts) und zurück sind Schalter erforderlich, die jedoch relativ kostengünstig als elektronische Schalter ausgeführt werden können, da die beschriebene Umschaltung nur zu einem Zeitpunkt erfolgen muss, zu dem alle Strings - wenn überhaupt nur - eine sehr geringe Leistung erzeugen. Geht man beispielsweise davon aus, dass bei einem String nachts ein Strom von 2 mA mit einer Spannung von bis zu 40 V eingeprägt wird (diese geringe Spannung stellt keine Gefahr im Sinne der Personensicherheit dar) ist für die nächtliche Stringüberwachung pro String eine Leistung von ca. 100 mW erforderlich.

Wenn bei der Überwachung eines unbeleuchteten Strings der Arbeitspunkt so gewählt wird, dass in jedem Modul mindestens ein Bypass-Netzwerk im Zustand 223 oder 224 arbeitet, dann ist eine Versorgung einer Daten verarbeitenden Einheit in jedem Modul gesichert. Damit kann die Daten verarbeitende Einheit komplexere Signalverarbeitungen vornehmen und insbesondere mit einer drahtlosen oder drahtgebundenen Kommunikations-Schnittstelle versehen werden, über die mit dem String-Überwachungs-Server (der ebenfalls mit einer korrespondierenden Kommunikationsschnittstelle versehen ist) kommuniziert werden kann.

Hierzu könnte beispielsweise (über ein Bypass-Netzwerk in jedem Modul) jedes Modul individuell adressiert werden und mit individuellen geheimen Codes (abhängig von Seriennummer und Zeitpunkt) aktiviert werden. Sofern ein Modul über einen längeren Zeitraum hinweg (mehrere Tage, Wochen, Monate) nicht aktiviert wurde kann das Modul mit Hilfe des zusätzlichen Schalters des Bypass-Netzwerks kurzgeschlossen werden und damit für eine Dieb wertlos machen.

Die Kommunikations-Schnittstelle jedes Bypass-Netzwerk könnte beispielsweise einen ZigBee Router oder ein ZigBee End-Device enthalten. Der dazugehörende ZigBee Coordinator könnte demzufolge Teil der Kommunikationsschnittstelle des String-Überwachungs-Server.

Wenn das Bypass-netzwerk mit einer digitalen Kommunikations-Schnittstelle versehen ist, können mit geringem Zusatzaufwand auch andere attraktive Funktionen realisiert werden.

Das Bypass-Netzwerk könnte dann auch mit weiteren Funktionen versehen werden, die dann arbeiten sind, wenn die Teilstrings Energie abgeben, d. h. wenn die herkömmlichen Bypass-Netzwerke nicht aktiv sind. In diesem Fall steht eine ausreichend hohe Spannung von den dem Bypass-Netzwerk parallel geschalteten Solarzellen (in der Regel sind dabei mehrere Zellen seriell verschaltet) zur Verfügung, so dass es leicht ist, die Stromversorgung für diese zusätzlichen Funktionen zur Verfügung zu stellen. Insbesondere ist es vorteilhaft, wenn das erfindungsgemäße Bypass-Netzwerk auch die Spannung eines Teilstrings (bzw. eines PV-Moduls) ermittelt und über die Kommunikationsschnittstelle an den String-Überwachungs-Server weiterleitet. Dies stellt eine große Hilfe bei der Fehlersuche in Solarparks dar, da üblicherweise der Strom der einzelnen Strings gemessen wird und damit der Strom jedes Moduls im String bekannt ist. Leider ist die Spannung der einzelnen Module bisher erheblich schwieriger zu ermitteln sodass eine Modulintegrierte Spannungsmessung sehr hilfreich wäre. Insbesondere ist es damit sehr leicht, defekte oder schlecht arbeitende PV-Module in einem Solarpark zu identifizieren. Weitere interessante Funktionen sind:
- Ergänzung des Bypass-Netzwerks mit Sensoren für Strom, Spannung, Leckstrom, Temperatur, mechanischen Stress (Durchbiegung, Vibration), ...
- Speichern und Auslesen der History des Moduls
- Sicherheitsfunktionen, bei denen das Modul über die drahtlose Schnittstelle kurzgeschlossen werden kann (z. B. bei Brand oder Personengefährdung) und der Kurzschluss auch wieder aufgehoben werden kann.
- Sicherheitsfunktionen, bei denen das Modul automatisch kurgeschlossen werden kann z. B. bei Übertemperatur (Brand)

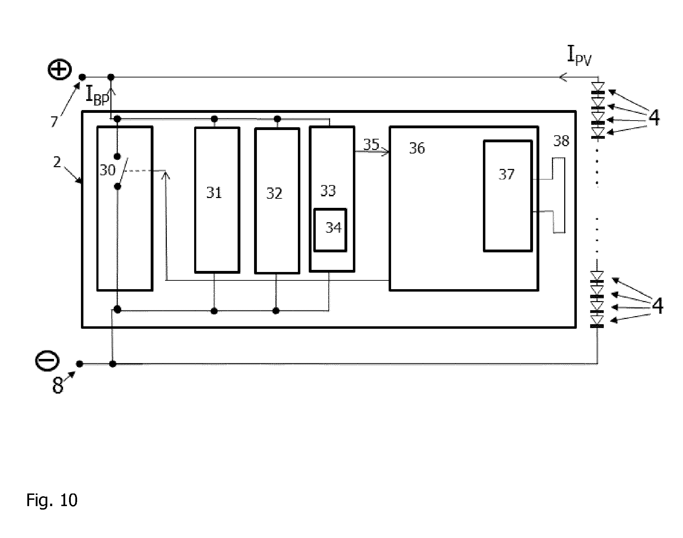

Fig. 10 zeigt das Blockschaltbild einer Realisierung des Bypass-Netzwerks.

Hierbei ist neben dem zusätzlichen Leistungs-Schalter 30 und dem DC-DC-Wandler 33 und dem Spannungsbegrenzenden Bauteil 31 noch das Kennlinien formende Netzwerk 32 enthalten. Weiterhin ist beim DC-DC-Wandler noch ein Energie-Speicher 34 vorgesehen (Kondensator). Bei der Daten verarbeitenden Einheit 36 wurde eine drahtlose Kommunikationsschnittstelle 37 mit Antenne 38 vorgesehen. Der Energie-fluss vom DC-DC-Wandler zur Daten verarbeitenden Einheit ist durch den Pfeil 35 veranschaulicht.

Eine Weiterbildung der Erfindung betrifft die elektrische Verschaltung des Bypass-Netzwerkes innerhalb des PV-Moduls.

Das Bypass-Netzwerk benötigt je eine elektrisch Verbindung zum Minus-Pol und zum Plus-Pol des parallel geschalteten Teilstrings. Je nach Verschaltung der Zellen innerhalb eines Moduls liegen der Plus- und der Minus-Anschluss nicht immer sehr nahe beieinander, so dass zumindest eine mehr oder weniger lange elektrische Leitung erforderlich ist, die auch einen hohen Strom (typische Ströme einer Zelle liegen heute bei ca. 9 A) leiten muss.

Bei einigen Modultypen, insbesondere bei Glas-Glas Modulen kann der Modulwirkungsgrad dadurch verbessert werden, dass Licht, das von vorne auf das Modul auftrifft und das im Zwischenraum zwischen zwei nebeneinander liegenden Zellen (und nahe der Ränder von am Rand liegenden Zellen) auf das Modulrückglas trifft (und bei Glas-Gas-Modulen mit hoher Wahrscheinlichkeit an der Modulrückseite wieder austritt) möglichst gut reflektiert wird, so dass eine gute Wahrscheinlichkeit besteht, dass das Licht über weitere Reflexionen wieder auf eine lichtempfindliche Fläche einer Zelle gelenkt wird und damit zur Stromerzeugung beträgt. Bei einigen Modulen wird daher auf das Rückglas ein gut reflektierendes Gittermuster aufgedruckt, wodurch ein Teil des Lichts, das sonst für die Stromerzeugung verloren wäre direkt oder indirekt auf Licht-empfindliche Bereiche der Zellen gelenkt werden.

Es wurde gefunden, dass die Funktion der elektrischen Verschaltung des Bypass-Netzwerks im Modul geschickt mit der Funktion der Reflexion des Lichts im Zwischenraum zwischen benachbarten Zellen kombiniert werden kann. Hierzu werden auf der Innenseite des Rückglases des Moduls gut reflektierende und gut leitende Streifen aufgebracht so dass diese dann ein Gitter bilden (wobei die Gitterperiode im Wesentlichen durch die Kantenlängen der Zellen bestimmt sind, d. h. die Gitterperiode in x- und y-Richtung ist um den Zwischenraum zwischen zwei benachbarten Zellen größer als die Kantenlänge der Zellen in x- und y -Richtung), so dass zwischen nebeneinander liegenden Zellen und im Randbereich von am Rand des Moduls liegenden Zellen das Licht möglichst gut auf strom-erzeugende Bereiche der Zellen gelenkt wird. Die Streifen müssen dazu nur wenige mm breit (z. B. 3 mm ... 10 mm) sein. Die Streifen können beispielsweise durch einen leitenden Lack hergestellt werden oder aber durch Aluminiumstreifen. Um die Reflexionseigenschaften der leitenden Streifen zu optimieren, können diese noch geprägt werden (um eine diffuse Reflexion zu erreichen) oder mit eine zusätzlichen Oberflächenbeschichtung versehen sein.

Die Streifen liegen direkt auf der Innenseite des Rückglases auf, und sind durch das Einbettungsmaterial, das die PV-Zellen umgibt von den Zellen elektrisch isoliert. Reflektierende Gitter werden heute schon bei einer Reihe von Glas-Glas Modulen verwendet, jedoch sind diese nur reflektierend und haben nicht die Zusatzfunktion der Verschaltung von Bypass-Netzwerken.

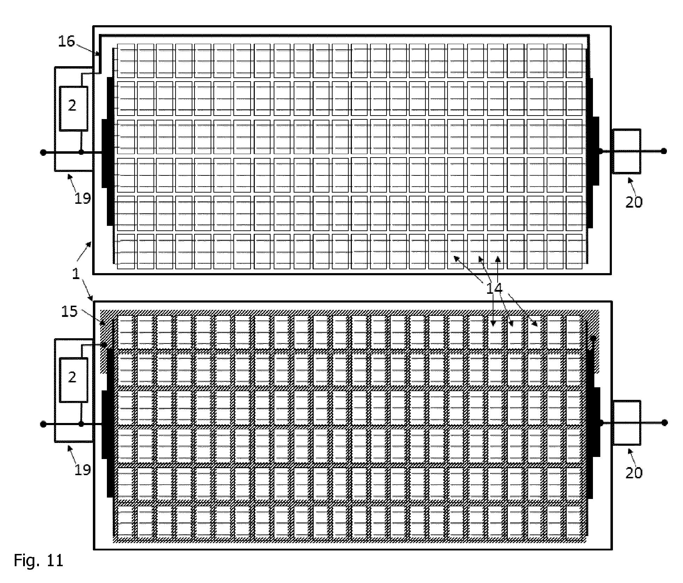

Fig. 11 zeigt diese besonders vorteilhafte Verschaltung des Bypass-Netzwerks beispielhaft bei einem Modul das aus 6 Reihen von halben Zellen besteht. Innerhalb einer von links nach rechts verlaufenden Reihe sind die Zellen jeweils seriell verschaltet wobei die 6 Reihen dann parallel geschaltet sind. Durch das reflektierende und leitfähige Gitter, das hinter den Zellen liegt, wird die Verbindung zwischen dem am linken Rand in der Anschlussdose befindlichen Bypass-Netzwerk und dem auf der rechten Seite befindlichen zweiten elektrischen Modulanschluss hergestellt.

Zum Vergleich ist in der oberen Hälfte von Fig. 11 ein Modul bei dem für die Verschaltung des Bypass-Netzwerks eine eigene Leitung 16 gelegt ist und in der unteren Hälfte ein vergleichbares Modul mit dem leitfähigen Gitter (15 schraffiert) gezeigt. Das schraffierte Gitter ist hierbei links und rechts noch erweitert mit Bereichen, an denen das Gitter gut kontaktiert werden kann und mit Leitern zum Bypass-Netzwerk und zu den Zellen verbunden ist.

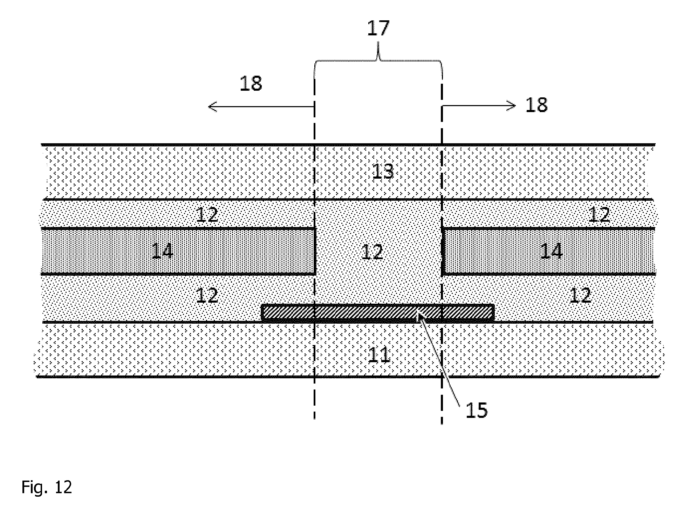

Fig. 12 zeigt den Aufbau eines erfindungsgemäßen Glas-Glas Moduls, bei dem unten das Rückglas 11 liegt. Es ist ein Schnitt durch das Modul im Bereich zweier benachbarter Zellen gezeigt. Im Bereich 17, dem Zwischenraum zweier benachbarter Zellen sowie dem Randbereich um eine Zelle ist auf der Innenseite des Rückglases mit einem gewissen Überlapp zum Zellbereich 18 die elektrisch gut leitende und reflektierende Schicht 15 aufgebracht mit dem Muster eines Gitters (wenn man die Projektion auf die Fläche des Rückglases betrachtet). Auf dem Rückglas mit der leitenden Schicht liegt dann das Einbettungsmaterial 12 für die Zellen 14, das gleichzeitig eine elektrische Isolation der Zellen voneinander und der Zellen von der leitenden Schicht 15 auf der Rückwand ermöglicht. Dieses Einbettungsmaterial umgibt die Zellen von allen Seiten und stellt gelichzeitig die mechanisch Verbindung der Zellen mit dem darüber liegenden Frontglas 13 und dem darunter liegenden Rückglas 11 her.

Die leitfähigen Streifen dürfen keinen zu hohen elektrischen Widerstand haben (insgesamt sollte der gesamte Widerstand des Gitters deutlich unter 1 Ohm liegen) und sollten auch nicht zu dick sein. Aus diesem Grund wird ein gut leitendes material benötigt. Insbesondere könnten diese Streifen aus Aluminium bestehen, wobei das Aluminium noch zur Optimierung der Reflexionseigenschaften beschichtet und / oder geprägt (diffuse Reflexion) sein kann.

Wie beschrieben wird die Stromversorgung für die Daten verarbeitende Einheit des Bypass-Netzwerks dadurch bereitgestellt, dass das Bypass-Netzwerk immer wieder den zusätzlichen Leistungsschalter abschaltet, wodurch aber die Verlustleistung des Bypass-Elements kurzzeitig deutlich ansteigt. Diese hohe Verlustleitung ist unerwünscht, da ja dafür gesorgt werden muss, dass diese Wärme auch abgeführt wird. Mit dem beschriebenen leitfähigen Gitter ist es möglich, dass bei hohem Strom und aktivem Bypass der Spannungsabfall in dem leitfähigem Gitter (oder einem Teil des Gitters) dazu verwendet wird die Energie für die Versorgung des Bypass-Netzwerkes zur Verfügung zu stellen.

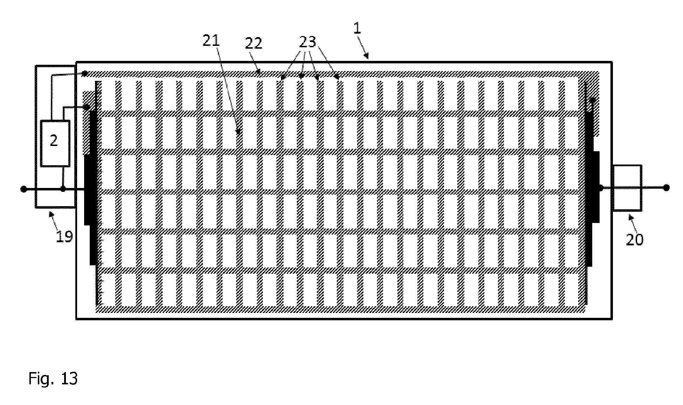

Fig. 13 zeigt dazu wie auf der Basis des in Fig. 11 gezeigten Moduls dafür das Gitter modifiziert werden könnte. Die elektrischen Leiter des Gitters werden dazu gezielt an mehreren Stellen 23 unterbrochen, so dass vom elektrischen Modulanschluss 20, der weit vom Bypass-Netzwerk entfernt liegt, zwei getrennte Strompfade 21 und 22 zum Bypass-Netzwerks 2 vorhanden sind und das Bypass-Netzwerk über einen zusätzlichen Anschluss zur Stromversorgung verfügt. Über den einen Strompfad fließt bei aktivem Bypass-Netzwerk der größte Anteil des Stroms, so dass in diesem Pfad 21 ein deutlicher Spannungsabfall auftritt (z. B. einige 100 mV, die für die Versorgung des Bypass-Netzwerkes ausreichen). Über den zweiten Pfad fließt nur ein geringer Versorgungsstrom für das Bypass-Netzwerk, so dass hier kein wesentlicher Spanungsabfall auftritt, und somit eine elektrische Versorgungsspannung von einigen 100 mV für das Bypass-Netzwerk zur Verfügung steht. Damit kann erreicht werden, dass im Falle, eines hohen Bypass-Stromes das Bypass-Netzwerk dadurch mit Energie versorgt wird, und der zusätzliche Leistungsschalter bei hohen Strömen nicht mehr abschalten muss, und somit eine geringere Verlustleistung im Bypass-Netzwerk anfällt. Gelichzeitig ist zu bemerken, dass in dem leitfähigen Gitter natürlich eine zusätzliche Verlustleitung anfällt, die jedoch wegen der geringen Leistungsdichte leicht abgeführt werden kann.

Im Folgenden wird die Erfindung beispielhaft anhand der beiliegenden Figuren erläutert. Es zeigen:
- Fig. 1:: PV-String
- Fig. 2:: Beispielhafte Kennlinie von Teilstring
- Fig. 3:: Drei Teilstrings mit Bypassdiode wobei der mittlere Teilstring verschattet ist
- Fig. 4:: Beispielhafte Kennlinie von Teilstring mit Bypassdiode
- Fig. 5:: Beispiele für Teilstrings mit parallel geschalteten Bypass-Netzwerken
- Fig. 6:: PV-String mit Bypass-Netzwerk
- Fig. 7:: Arbeitsbereiche von Bypass-Netzwerk im Fall einer Bypass Diode
- Fig. 8:: Arbeitsbereiche von Bypass-Netzwerk im Fall eines Smart PV-Bypass
- Fig. 9:: Arbeitsbereiche des Bypass-Netzwerks des erfindungsgemäßen Moduls
- Fig. 10:: Blockschaltbild einer möglichen Realisierung des Bypass-Netzwerks
- Fig. 11:: Zwei Versionen von PV Modul mit Bypass-Netzwerk, das einmal mit einer zusätzlichen Leitung und einmal über das leitfähige Gitter angeschlossen ist
- Fig. 12:: Aufbau von Glas-Glas Modul mit gut reflektierenden und elektrisch gut leitenden Streifen die auf der Innenseite des Rückglases angebracht sind.
- Fig. 13:: Leitfähiges Gitter bei dem von einem Anschluss eines Teilstrings zwei getrennte Strompfade zum Bypass-Netzwerk führen

### Bezugszeichenliste:

- 1: Solarmodul
- 2: Bypass-Netzwerk
- 3: Bypass-Diode
- 4: Solarzelle
- 5: Plus-Pol des Bypass Netzwerks
- 6: Minus-Pol des Bypass-Netzwerks
- 7: Plus-Pol eines Teil-Strings (bzw. eines Moduls) mit Bypass-Netzwerk
- 8: Minus-Pol eines Teil-Strings (bzw. eines Moduls) mit Bypass-Netzwerk
- 9: Anschlussbox (J-Box) für Plus
- 10: Anschlussbox (J-Box) für Minus
- 11: Rückglas
- 12: Einbettungsmaterial
- 13: Frontglas
- 14: Solarzelle
- 15: elektrisch leitfähige und gut reflektierende Schicht, die in Streifen auf dem Rückglas im Wesentlichen in Form eines Gitters aufgebracht ist
- 16: Leitung zum Anschluss des Bypass-netzwerks
- 17: Randbereich um Zelle, bzw. Zwischenraum zwischen zwei Zellen
- 18: Zellbereich = Bereich (senkrechte Projektionsfläche der Zellen auf das Rückglas) eines Moduls in dem Zellen liegen
- 19: Modulanschlussdose mit Bypass-Netzwerk
- 20: Modulanschlussdose weit entfernt von Bypass Netzwerk
- 21: Strompfad über den Bypass-Strom fließt
- 22: Strompfad zur Versorgung des Bypass-Netzwerks
- 23: Auftrennung des leitfähigen Gitters
- 30: zusätzlicher Leistungsschalter
- 31: Bauteil, das die negative Spannung über dem Bypass begrenzt
- 32: Kennlinien formendes Netzwerk
- 33: DC-DC-Wandler
- 34: Energie-Speicher im DC-DC-Wandler
- 35: Energie-Versorgung für Daten verarbeitende Einheit
- 36: Daten verarbeitende Einheit
- 37: Drahtlose Kommunikationsschnittstelle der Daten verarbeitende Einheit
- 38: Antenne für drahtlose Kommunikationsschnittstelle

- 100: Bypass-Netzwerk ist nicht aktiv
- 200: Das durch eine Diode gebildete Bypass-Netzwerk ist aktiv
- 210: Bypass-Netzwerk ist aktiv. Zusätzlicher Leistungsschalter ist eingeschaltet
- 220: Bypass-Netzwerk ist aktiv. Zusätzlicher Leistungsschalter ist abgeschaltet
- 221: Bypass-Netzwerk ist aktiv. Zusätzlicher Leistungsschalter ist abgeschaltet. Strom durch Bypass Netzwerk ist vernachlässigbar. Ein Übergang in Arbeitsbereich 210 ist nicht möglich.
- 222: Bypass-Netzwerk ist aktiv. Zusätzlicher Leistungsschalter ist abgeschaltet. Strom durch Bypass Netzwerk fließt im Wesentlichen durch DC-DC Wandler bzw. das Kennlinien formende Netzwerk bestimmt; Ein Übergang in Arbeitsbereich 210 ist nicht möglich.
- 223: wie 222 wobei hier die Daten verarbeitende Einheit über DC-DC-Wandler mit Energie versorgt wird und arbeitet. Ein Übergang in Arbeitsbereich 210 ist nicht möglich.
- 224: Bypass-Netzwerk ist aktiv. Zusätzlicher Leistungsschalter ist abgeschaltet. Strom fließt im Wesentlichen durch spannungsbegrenzende Diode, und die Daten verarbeitende Einheit arbeitet. Ein Übergang in Arbeitsbereich 210 ist nicht möglich.
- 225: Bypass-Netzwerk ist aktiv. Strom fließt im Wesentlichen durch spannungsbegrenzende Diode. Die Daten verarbeitende Einheit arbeitet. Arbeitsbereich ist nicht dauerhaft stabil, da Leistungsschalter eingeschaltet wird, wodurch das Bypass-Netzwerk in Arbeitsbereich 210 übergeht.

- I, II, III, IV:: Die vier Quadranten im I(U) Kennlinien Diagramm des Bypass-Netzwerks
- U_{OC}: Leerlaufspannung von Teilstring
- Isc: Kurzschlussstrom von Teilstring
- U_{BP}: Spannung zwischen Plus- und Minus-Anschluss des Bypass-Netzwerks
- U_{Lim}: Negative Spannung auf die Bypassdiode begrenzt
- I_{PV}: Strom durch PV-String: Strom der am Plus-Anschluss der Teil-Strings von den Solarzellen herausfließt
- I_{PV,1}, I_{PV,2}, I_{PV,3}: I_{PV}: von Teilstring 1, 2 oder 3
- I_{BP}: Bypass-Strom, d. h. Strom der am Plus-Anschluss des Bypass-Netzwerks herausfließt
- I_{BP,1}, I_{BP,2}, I_{BP,3}:: Bypass-Strom von Teilstring 1, 2 oder 3
- Uₛₜₐᵣₜ: Spannung über dem Bypass-Netzwerk an der Grenze zwischen Arbeitsbereich 222 und 223. Sofern eine höhere negative Spannung als Uₛₜₐᵣₜ am Bypass-Netzwerk anliegt werden die Systemteile des Bypass-Netzwerks ausreichend mit Leistung versorgt. Der Wert von Uₛₜₐᵣₜ ist eine negativer Spannung.
- Iₛₜₐᵣₜ: Strom der bei Uₛₜₐᵣₜ am Bypass-Netzwerk anliegt
- U_{trig}: Negativer Spannungswert, den Bypass-Spannung unterschreiten muss damit der zusätzlichen Leistungsschalter eingeschaltet wird.

## Patentansprüche

1. Photovoltaik-Modul mit mindestens einem Bypass-Netzwerk mit Daten verarbeitende Einheit, das in Verbindung mit einem für mindestens einen gesamten Modulstring vorgesehenen Stringüberwachungs-Server eine einfache und kosteneffektive Erkennung von Störungen im Stromkreis auch bei nachts unbeleuchteten PV-Modulen ermöglicht
**dadurch gekennzeichnet, dass**
das Bypass-Netzwerk gebildet wird durch die Parallelschaltung eines die negative Spannung über dem Bypass begrenzenden Bauteils,
eines zusätzlichen Leistungsschalters
sowie des Eingangs eines DC-DC Spannungswandlers
wobei das Bypass-Netzwerk im aktiven Bereich - sofern der Strom durch das Bypass-Netzwerk unterhalb des Trigger-Stromes liegt - dauerhaft einen ersten aktiven Zustand einnehmen kann
in dem der zusätzliche Leistungsschalter nicht eingeschaltet ist,
und in dem ein signifikanter Strom über das Bypass-Netzwerk fließt,
wobei der DC-DC Spannungswandler in der Lage ist, die zum Bypass-Netzwerk gehörende Daten verarbeitende Einheit, die bei Bedarf den zusätzlichen Leistungsschalter ansteuert, mit Energie zu versorgen sofern die Spannung über dem Bypass-Netzwerk negativer wird als die Start-up-Spannung (Uₛₜₐᵣₜ) des DC-DC-Wandlers.

2. Photovoltaik-Modul mit mindestens einem Bypass-Netzwerk nach Anspruch 1, **dadurch gekennzeichnet, dass** zum Bypass-Netzwerk noch ein Kennlinien-formendes Netzwerk durch Parallelschaltung hinzugefügt ist, wobei das Kennlinienformende Netzwerk aus einer Serienschaltung von Widerstand und Schottkydiode besteht.

3. Photovoltaik-Modul mit mindestens einem Bypass-Netzwerk nach Anspruch 1 oder 2, **dadurch gekennzeichnet, dass** Daten verarbeitende Einheit des Bypass-Netzwerks noch eine drahtgebundene digitale Kommunikationsschnittstelle beinhaltet, über die die Daten verarbeitende Einheit des Bypass-Netzwerks mit dem Stringüberwachungs-Server Informationen austauschen kann.

4. Photovoltaik-Modul mit mindestens einem Bypass-Netzwerk nach Anspruch 1 oder 2, **dadurch gekennzeichnet, dass** die Daten verarbeitende Einheit des Bypass-Netzwerks noch eine drahtlose digitale Kommunikationsschnittstelle beinhaltet, über die die Daten verarbeitende Einheit des Bypass-Netzwerks mit dem Stringüberwachungs-Server Informationen austauschen kann.

5. Photovoltaik-Modul mit mindestens einem Bypass-Netzwerk nach Anspruch 3 oder 4, **dadurch gekennzeichnet, dass** dem Bypass-Netzwerk ein Sensor für die Modulspannung hinzugefügt wird, dessen Messwerte bei bestrahlten Zellen über die Kommunikationsschnittstelle an den Stringüberwachungs-Server geschickt werden können.

6. Bypass-Element mit Daten verarbeitender Einheit für Photovoltaik-Modul nach Anspruch 1,2,3, 4 oder 5, **dadurch gekennzeichnet, dass** das Bypass-Netzwerk gebildet wird durch die Parallelschaltung
eines die negative Spannung über dem Bypass-Netzwerk begrenzenden Bauteils, eines zusätzlichen Leistungsschalters
sowie des Eingangs eines DC-DC Spannungswandlers
wobei das Bypass-Netzwerk im aktiven Bereich - sofern der Strom durch das Bypass-Netzwerk unterhalb des Trigger-Stromes liegt - dauerhaft einen ersten aktiven Zustand einnehmen kann
in dem der zusätzliche Leistungsschalter nicht eingeschaltet ist,
und in dem ein signifikanter Strom über das Bypass-Netzwerk fließt,
wobei der DC-DC Spannungswandler in der Lage ist, die zum Bypass-Netzwerk gehörende Daten verarbeitende Einheit, die bei Bedarf den zusätzlichen Leistungsschalter ansteuert, mit Energie zu versorgen sofern die Spannung über dem Bypass-Netzwerk negativer wird als die Start-up-Spannung (Uₛₜₐᵣₜ) des DC-DC-Wandlers.

7. Photovoltaik-Modul mit einem Frontglas und einem Rückglas mit mindestens einem Bypass-Netzwerk, **dadurch gekennzeichnet** das
auf die Innenseite des Rückglases reflektierende Streifen aufgebracht werden, die das Muster eines Gitter bilden und die Licht, das durch die Zwischenräume zwischen benachbarten Zellen auf diese Streifen trifft, reflektieren so dass das Licht nicht für die Stromerzeugung verloren ist, sondern mit einer guten Wahrscheinlichkeit auf eine Zelle gelenkt wird und zur Stromerzeugung beitragen kann, wobei die reflektierenden Streifen eine gute elektrische Leitfähigkeit aufweisen und gleichzeitig für den Stromtransport zum Bypass-Netzwerk genutzt werden.

8. Photovoltaik-Modul nach Anspruch 7, **dadurch gekennzeichnet, dass** es ein Bypass-netzwerk nach Anspruch 6 beinhaltet und dieses über einen zusätzlichen elektrischen Anschluss für die Stromversorgung verfügt und dass es bei dem Gitter aus den leitfähigen Steifen ab einem gewissen Punkt zwei getrennte Pfade zu zwei verschiedenen Anschlüssen des Bypass Netzwerk gibt.
